# EUROPEAN PATENT APPLICATION

(11) **EP 2 109 155 A2**
(43) Date of publication of application: **14.10.2009**
(21) Application number: 09157764.3
(22) Date of filing: 09.04.2009
(51) Int. Cl.: H01L 31/075, H01L 31/18

(54) **Thin film silicon solar cell and manufacturing method thereof**

(30) Priority: 10.04.2008 KR 20080033278
(71) Applicant: KISCO Corporation, Changwon-si Gyeongsangnam-do (KR)
(72) Inventor: Myong, Seung-Yeop, Seoul (KR)
(74) Representative: Zardi, Marco

(57) **Abstract**

A thin film silicon solar cell comprises a front transparent electrode, a p-type window layer, a buffer layer, an i-type absorber layer, an n-type layer and a metal rear electrode. The front transparent electrode is stacked on a transparent substrate. The p-type window layer is stacked on the front transparent electrode, and has a thickness in a range of 12 nm to 17 nm. The buffer layer is stacked on the p-type window layer, and has a carbon concentration in a range of 0.5 to 3.0 atomic % and a thickness in a range of 3 to 8 nm. The i-type absorber layer is stacked on the buffer layer. The n-type layer is stacked on the i-type absorber layer. The metal rear electrode is stacked on the n-type layer.

## Description

### BACKGROUND

### 1. Field

The embodiment relates to a thin film silicon solar cell and manufacturing method thereof.

### 2. Description of the Related Art

Hydrogenated amorphous silicon (a-Si) solar cells have been widely studied due to high photosensitivity in a visible light region, easy control of an optical band gap, cost effective, low temperature, and large area process possibility. Further, there have been many attempts to reduce Stabler-Wronski effect of amorphous silicon materials. As a result, methods for diluting a silane (SiH₄) with hydrogen (H₂) have been developed.

In order to develop high-efficiency thin film silicon solar cell, it is essential to form an absorber with a low light-induced degradation and to form a highly conductive and wide band gap p-type window layer capable of minimizing its absorption of visible light and of applying a strong electric field thereto. Accordingly, the p-type window layer should have a wide optical band gap and high electric conductivity. A p-type window forming hetero-junction at the interface between the p-type window layer and an i-type absorber layer has been widely used.

However, an abrupt optical band gap difference at hetero-junction interface between the p-type window layer and the i-type absorber layer increases a defect density at the interface, and thereby causing recombination loss. Further, if carbon is introduced to the p-type window layer to enhance the optical band gap , it limits the overall cell performance due to a high series resistance.

Studies on the reduction of the recombination loss at the interface have been actively performed all over the world. So as to improve interface features between the p-type window layer and the i-type absorber layer, various buffer layers have been developed.

For example, Japanese Tokyo Institute of Technology firstly developed a graded band gap i-a-SiC:H buffer layer manufactured by gradually reducing carbon content, and inserted it at the interface between a p-type window layer and an i-type absorber layer (p-a-SiC:H/i-a-Si:H) in 1984. U.S.A. Solarax corporation developed an amorphous silicon (a-Si:H) solar cell in which a graded band gap i-a-SiC:H buffer layer is inserted by plasma-enhanced chemical vapor deposition (PECVD). In addition, Tokyo Institute of Technology also developed a thin film silicon solar cell with a structure of glass/SnO2/p-a-SiC:H/graded band gap i-a-SiC:H/i-a-Si:H/n-µc-Si:H/Ag structure (area: 0.09 cm²) by photo-CVD.

However, because a graded band gap i-a-SiC:H buffer layer deposited without hydrogenated dilution has a large dangling bond defect density, recombination loss at the interface between the p-type window layer and the i-type absorber layer is still high. Further, the graded band gap i-a-SiC:H buffer layer has a disadvantage that efficiency of a solar cell is reduced due to a low electric conductivity thereof.

Meanwhile, Korea Advanced Institute Science and Technology developed a double p-a-SiC:H (undiluted p-a-SiC:H window layer + high hydrogen diluted p-a-SiC:H) structure by photo-CVD. The double p-a-SiC:H structure minimizes light absorption in a p-type window layer, and effectively reduces recombination at the interface between a p-type window layer and an i-type absorber layer, and thereby improving efficiency of a solar cell based on a p-i-n type amorphous silicon.

However, since the photo-CVD method has a low deposition rate and a thin film is coated on a quartz window transmitting ultraviolet light during deposition, after a vacuum of a chamber is broken and the thin film is removed from the quartz window, the chamber should be baked in order to again maintain high vacuum. Thus, it takes long time to produce the solar cell. Accordingly, the photo-CVD method is not suitable for mass production of the solar cell.

### SUMMARY

In one aspect, a thin film silicon solar cell comprises a front transparent electrode stacked on a transparent substrate, a p-type window layer stacked on the front transparent electrode, and having a thickness in a range of 12 nm to 17 nm, a buffer layer stacked on the p-type window layer, having a carbon concentration in a range of 0.5 to 3.0 atomic % and a thickness in a range of 3 to 8 nm, an i-type absorber layer stacked on the buffer layer, an n-type layer stacked on the i-type absorber layer, and a metal rear electrode stacked on the n-type layer.

The buffer layer may include a hydrogenated amorphous silicon carbide.

The p-type window layer may have an electric conductivity of 1x10-6 S/cm.

The p-type window layer may include a hydrogenated amorphous silicon carbide.

The p-type window layer may have a constant optical band gap.

In other aspect, a method for manufacturing a thin film silicon solar cell comprises stacking a front transparent electrode on a transparent substrate, stacking a p-type window layer on the front transparent electrode to have a silane concentration in a range of 5 to 10 % and a thickness in a range of 12 nm to 17 nm, stacking a buffer layer stacked on the p-type window layer to have a silane concentration in a range of 0.5 to 5 % and a thickness in a range of 3 to 8 nm, stacking an i-type absorber layer on the buffer layer, stacking an n-type layer on the i-type absorber layer and stacking a metal rear electrode on the n-type layer.

The buffer layer may be formed by a flow rate ratio of a boron source gas ranging from 100 to 2000 ppm in the step of stacking the buffer layer.

The buffer layer may have a carbon concentration in a range of 0.5 to 3.0 atomic %.

The p-type window layer and the buffer layer may be formed by reaction gas comprising silane (SiH₄), hydrogen (H₂), boron source gas, and carbon source gas.

A temperature of the transparent substrate may range from 100 to 200 □ during deposition of the p-type window layer.

A base pressure of a reaction chamber may range from 10⁻⁷ to 10⁻⁵ Torr during deposition of the p-type window layer.

A deposition pressure of a reaction chamber may range from 0.4 to 2 Torr during deposition of the p-type window layer.

The p-type window layer may have an electric conductivity of 1x10⁻⁶ S/cm.

### BRIEF DESCRIPTION OF THE DRAWINGS

FIG. 1 is a cross-sectional view illustrating a single junction pi-n type amorphous thin film silicon solar cell in accordance with an embodiment;

FIG. 2 is a flow chart illustrating a method for manufacturing a thin film silicon solar cell in accordance with an embodiment;

FIG. 3 is a flow chart illustrating a formation procedure of a p-type window layer in the manufacturing method shown in FIG. 2; and

FIG. 4 is a flow chart illustrating a formation procedure of a buffer layer in the manufacturing method shown in FIG. 2.

### DETAILED DESCRIPTION OF EMBODIMENTS

The present embodiments will be described in detail with reference to accompanying drawings.

A thin film silicon solar cell according to the present embodiment has a structure in which a plurality of unit cells are electrically connected to each other in serial on a transparent substrate 10 such as a glass substrate or a transparent plastic substrate.

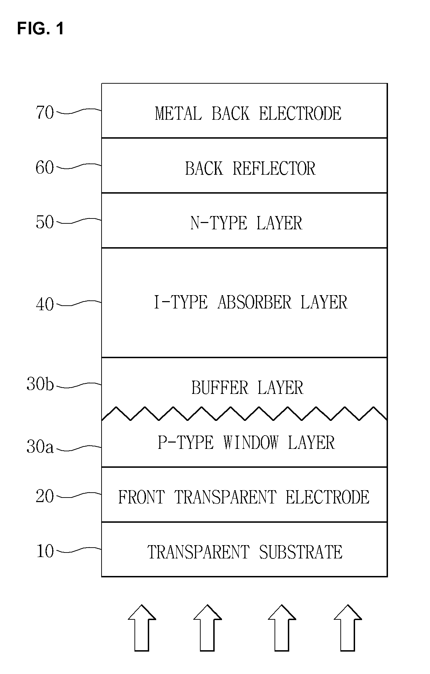

FIG. 1 is a cross-sectional view illustrating a single junction pi-n type amorphous thin film silicon solar cell in accordance with an embodiment. Referring to FIG. 1, a thin film silicon solar cell includes a front transparent electrode 20 which is formed on a transparent substrate 10 and on which a surface texture is formed; an amorphous silicon carbide (p-a-SiC:H) window layer 30a (referred to as 'p-type window layer' hereinafter) low diluted with hydrogen on the front transparent electrode 20; an amorphous silicon carbide (p-a-SiC:H) buffer layer 30b (referred to as 'buffer layer' hereinafter) more highly diluted with hydrogen on the p-type window layer 30a than the hydrogen dilution of the p-type window layer 30a; and an i-type absorber layer 40, an n-type layer 50, a back reflector 60, and a metal back electrode 70 sequentially formed on the buffer layer 30b.

When carbon is supplied into a reaction chamber, the amorphous silicon carbide (p-a-SiC:H) buffer layer 30b is formed. By supply of a suitable amount of the carbon, an optical band gap of the buffer layer 30b is formed between optical band gaps of the p-type window layer 30a and the i-type absorber layer 40. Namely, the buffer layer 30b prevents abrupt changes of an optical band gap between the p-type window layer 30a and the i-type absorber layer 40, and carbon composition.

Upon formation of the p-type window layer 30a and the buffer layer 30b, hydrogen (H₂) dilution is achieved for the improvements of efficiency, film quality, and electric conductivity by removing dangling bonds. Upon formation of the p-type window layer 30a, if high hydrogen (H₂) dilution is achieved, the front transparent electrode 20 is etched by H₂ such that atoms forming the front transparent electrode 20 remain in the reaction chamber. Since the atoms act as impurities at the time of forming the i-type absorber layer 40, the amount of hydrogen (H₂) supplied during the formation of the p-type window layer 30a needs to be less than a predetermined value. Accordingly, the p-type window layer 30a is lowly diluted with hydrogen, and the buffer layer 30b is diluted with hydrogen more highly than hydrogen dilution of the p-type window layer 30a. Consequently, features (efficiency, film quality, and electric conductivity) of the p-type window layer 30a and the buffer layer 30b can be improved while preventing the features of the i-type absorber layer 40 from being deteriorated.

In the present embodiment, a p-i-n type thin film silicon solar cell is manufactured by Radio Frequency (RF) PECVD using plasma excitation frequency of 13.56 MHz or Very High Frequency (VHF) PECVD using plasma excitation frequency higher than 13.56 MHz. The increase in the plasma excitation frequency may increase the deposition rate. In this case, the thin film silicon solar cell in accordance with the present embodiment includes the p-type window layer 30a and the buffer layer 30b more highly diluted with hydrogen than the hydrogen dilution of the p-type window layer 30a so as to achieve high efficiency. In this case, the buffer layer 30b can have low boron doping concentration and low carbon concentration.

The silane is diluted with hydrogen. Accordingly, when the flow of the silane is high, the silane is low diluted with the hydrogen. The p-type window layer 30a is deposited under a condition that the flow rate of the silane of the p-type window layer 30a is higher than the flow rate of the silane of the buffer layer(30b) and carbon and boron doping concentrations of the p-type window layer 30a are higher than them of the buffer layer(30b). Accordingly, the p-type window layer 30a includes includes a lower hydrogen-diluted amorphous silicon carbide (p-a-SiC:H) than the hydrogen dilution of the buffer layer(30b).

Moreover, a back reflector 60 formed by CVD method is located on the n-type layer 50. When the back reflector 60 is formed by the CVD, a texture is formed on a surface of the back reflector 60. The texture of the back reflector 60 maximizes light trapping effect. The back reflector 60 may be made of zinc oxide (ZnO).

The metal back electrode 70 functions as an electrode simultaneously with reflecting light transmitting solar cell layers 30a, 30b, 40, and 50. The metal back electrode 70 is formed by CVD or sputtering using a conductive material such as zinc oxide (ZnO) or silver (Ag).

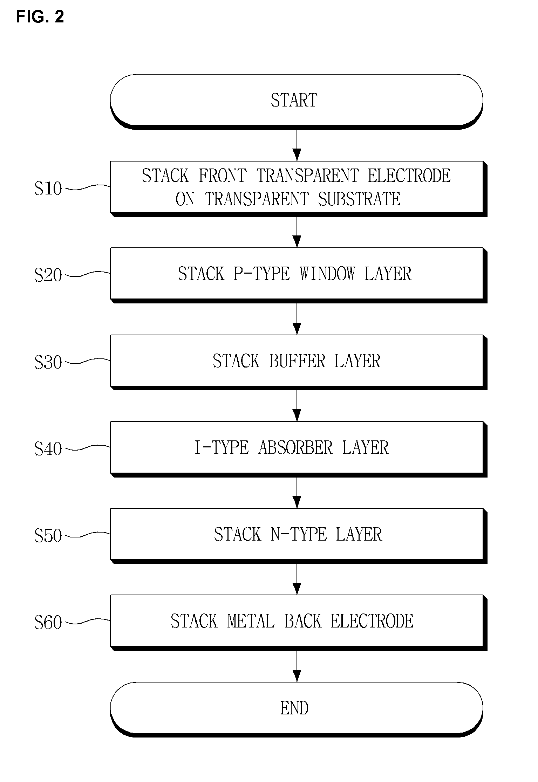

Reference will now be made in detail to a method for manufacturing a thin film silicon solar cell with the p-type window layer 30a and the buffer layer 30b, examples of which are illustrated in FIGS. 2 to 4.

Referring to FIG. 2, in order to manufacture an amorphous thin film silicon solar cell in accordance with the present embodiment, a front transparent electrode 20 is stacked on an insulation transparent substrate 10 such as glass or flexible polymer by coating a zinc oxide (ZnO) thin film or a tin oxide (SnO₂) thin film with a surface texture, for light trapping effect (S10).

In addition, for serial connection of unit cells, the front transparent electrode 20 is patterned by laser scribing and the like. So as to remove particles occurring during the patterning process, a cleaning process can be achieved. After the transparent substrate 10 on which the front transparent electrode 20 is stacked is loaded in a vacuum chamber of a PECVD system, moisture remaining on the transparent substrate 10 may be removed through preheating. Namely, the manufacturing method according to the present embodiment may further include a preheating procedure.

A p-type window layer 30a and a buffer layer 30b are sequentially stacked on the front transparent electrode 20 (S20 and S30).

An i-type absorber layer 40 is stacked on the buffer layer 30b. In this case, the i-type absorber layer 40 can include a variety of intrinsic absorbers. Here, each of the intrinsic absorbers according to the present embodiment may be one selected from the group consisting of a hydrogenated intrinsic amorphous silicon (i-a-Si:H), a hydrogenated intrinsic proto-crystalline silicon (i-pc-Si:H), a hydrogenated intrinsic proto-crystalline silicon multi-layer (i-pc-Si:H multilayer), a hydrogenated intrinsic amorphous silicon carbide (i-a-SiC:H), a hydrogenated intrinsic proto-crystalline silicon carbide (i-pc-SiC:H), a hydrogenated intrinsic proto-crystalline silicon carbide multi-layer (i-pc-SiC:H multilayer), a hydrogenated intrinsic amorphous silicon oxide (i-a-SiO:H), a hydrogenated intrinsic proto-crystalline silicon oxide (i-pc-SiO:H), and a hydrogenated intrinsic proto-crystalline silicon oxide multi-layer (i-pc-SiO:H multilayer).

A high efficiency double or triple-junction solar cell may be manufactured using a p-i-n type amorphous silicon with a double p-a-SiC:H structure comprising the p-type window layer 30a and the buffer layer 30b as top cell.

In a case of a p-i-n-p-i-n type double junction solar cell, an intrinsic absorber of a bottom cell may be formed by one selected from the group consisting of a hydrogenated intrinsic amorphous silicon (i-a-Si:H), a hydrogenated intrinsic amorphous silicon germanium (i-a-SiGe:H), a hydrogenated intrinsic proto-crystalline silicon germanium (i-pc-SiGe:H), a hydrogenated intrinsic nano-crystalline silicon (i-nc-Si:H), a hydrogenated intrinsic micro-crystalline silicon (i-µc-Si:H), and a hydrogenated intrinsic micro-crystalline silicon germanium (i-µc-SiGe:H).

In a case of a p-i-n-p-i-n-p-i-n type triple junction solar cell, an intrinsic absorber of a middle cell can be achieved by one selected from the group consisting of a hydrogenated intrinsic amorphous silicon germanium (i-a-SiGe:H), a hydrogenated intrinsic proto-crystalline silicon germanium (i-pc-SiGe:H), a hydrogenated intrinsic nano-crystalline silicon (i-nc-Si:H), a hydrogenated intrinsic micro-crystalline silicon (i-µc-Si:H), a hydrogenated intrinsic micro-crystalline silicon germanium, and a hydrogenated intrinsic micro-crystalline silicon germanium carbon (i-µc-SiGeC:H). An intrinsic absorber of a bottom cell may be made of one of a hydrogenated intrinsic amorphous silicon germanium (i-a-SiGe:H), a hydrogenated intrinsic proto-crystalline silicon germanium (i-pc-SiGe:H), a hydrogenated intrinsic nano-crystalline silicon (i-nc-Si:H), a hydrogenated intrinsic micro-crystalline silicon (i-µc-Si:H), and a hydrogenated intrinsic micro-crystalline silicon germanium (i-µc-SiGe:H).

An amorphous thin film silicon solar cell is manufactured by sequentially stacking an n-type layer 50 and a metal rear electrode 70 on the i-type absorber layer 40 (S50 and S60).

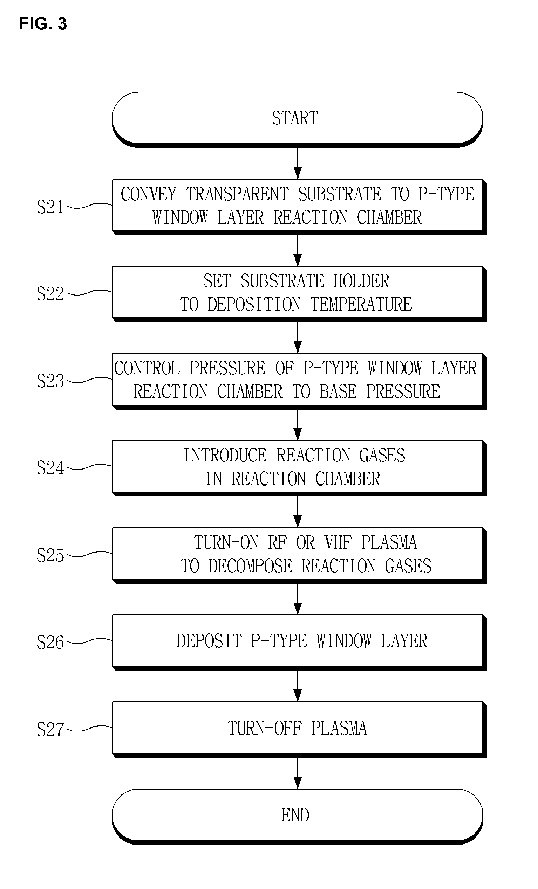

FIG. 3 is a flow chart illustrating a formation procedure of a p-type window layer in the manufacturing method shown in FIG. 2.

The transparent substrate 10 coated with a patterned front transparent electrode 20 is conveyed to a reaction chamber for depositing the p-type window layer 30a (S21).

At this time, a temperature of a substrate holder of the reaction chamber is set to a deposition temperature of the p-type window layer 30a (S22). The deposition temperature is a real temperature of the transparent substrate 10 while a low hydrogen-diluted p-type window layer 30a is being deposited, and the deposition temperature may range from 100 to 200 °C.

If the deposition temperature is lower than 100 °C, a deposition rate of a thin film may be reduced and a defect density may be increased. If the deposition temperature is higher than 200 °C, the transparent electrode 20 is extremely etched due to high energy hydrogen plasma, such that zinc (Zn), tin (Sn), or oxygen (O) atoms can be diffused to an intrinsic absorber of the p-type window layer 30a during manufacturing of a solar cell. Accordingly, since zinc, tin, or oxygen atoms of the etched transparent electrode 20 remain in the reaction chamber, they are diffused into the p-type window layer 30a, the buffer layer 30b, and the i-type absorber layer 40, respectively. Because the diffused atoms act as impurities to reduce quantum efficiency of the solar cell, conversion efficiency thereof is reduced.

Moreover, in a case of zinc oxide of the front transparent electrode 20, hydrogen acting as n-type dopant can be escaped from a surface or a grain boundary of the zinc oxide at a temperature greater than 200°C. Accordingly, resistivity may be increased to reduce efficiency of the solar cell.

Further, after the transparent substrate 10 coated with the patterned front transparent electrode 20 is conveyed to the reaction chamber, a pressure of the reaction chamber reaches a base pressure by operation of a high-vacuum pump such as a turbo molecular pump. Consequently, the reaction chamber becomes in a vacuum state (S23).

In this case, the base pressure may range from 10⁻⁷ to 10⁻⁵ Torr. When the base pressure is lower than 10⁻⁷ Torr, a high quality thin film with little contamination of oxygen or nitrogen can be deposited. However, it takes a long time to perform a deposition and throughput is reduced thereby. When the base pressure is higher than 10⁻⁵ Torr, high quality thin film cannot be obtained due to contamination of oxygen or nitrogen.

After the pressure of the reaction chamber reaches the base pressure, reaction gas are introduced in the reaction chamber (S24). The reaction gas comprises silane (SiH₄), hydrogen (H₂), boron source gas, and carbon source gas. The boron source gas can contain diborane (B₂H₆), trimethyl boron (TMB), or triethyl boron (TEB). The carbon source gas may contain one of methane (CH₄), ethylene (C₂H₄), and acetylene (C₂H₂). A flow rate of the respective source gas can be controlled by a mass flow controller (MFC).

When a pressure of the reaction chamber reaches a deposition pressure through introduction of the reaction gas, the deposition pressure is maintained constant at a preset value by a pressure controller and an angle valve connected to the reaction chamber. The deposition pressure is set as a value capable of obtaining thickness uniformity of the p-type window layer 30a, a high quality property, and an appropriate deposition rate.

The deposition pressure may range from 0.4 to 2 Torr. If the deposition pressure is less than 0.4 Torr, the thickness uniformity and the deposition rate of the p-type window layer 30a are reduced. If the deposition pressure is greater than 2 Torr, powder which occurs in a plasma reactor or the gas consumption are increased, which leads to an increase in running costs.

Meanwhile, a pressure in the reaction chamber reaches the deposition pressure, plasma is ignited in the reaction chamber to decompose the reaction gas (S25). Accordingly, a low hydrogen-diluted p-type window layer 30a is deposited on the transparent substrate 10 coated with the patterned front transparent electrode 20 (S26). In this case, the deposition thickness of the p-type window layer 30a ranges from 12 to 17 nm.

If a thickness of the p-type window layer 30a is less than 12 nm, because an electric conductivity is low, a strong electric field cannot be applied to an i-type absorber layer(40). This causes a reduction of an open-circuit voltage of the solar cell. If a thickness of the p-type window layer 30a is greater than 17 nm, optical absorption in the p-type window layer 30a almost free from contribution to a short-circuit current is increased to reduce a short-circuit current and thereby reducing conversion efficiency.

Since a constant composition of source gas is maintained during deposition, a hydrogen-diluted p-type window layer 30a with a constant optical band gap is formed. The p-type window layer(30a) with the constant optical band gap has a better reproductibility compared to a p-type window layer with a graded optical band gap.

The p-type window layer 30a may have an electric conductivity of about 1x10⁻⁶ S/cm, and have an optical band gap of about 2.0 eV. A silane concentration being a reference factor of a hydrogen dilution ratio may be in the range of 5 to 10%. That is, if the silane concentration is less than 5%, the damage on a surface of the front transparent electrode 20 is increased due to an atomic hydrogen with a high energy in an initial deposition stage. If the silane concentration is greater than 10%, a deposition speed of the p-type window layer 30a is too fast to control a thickness of the p-type window layer 30a, and the structural disorder of the p-type window layer 30a may be increased, and thereby increasing a defect density such as a dangling bond concentration. The silane concentration is a ratio of a flow rate of silane to a sum of the flow rate of the silane and a flow rate of hydrogen gas, and the flow rate of the silane and a flow rate of hydrogen gas are controlled by mass flow controllers.

Further, a flow rate of the boron source gas and a flow rate of the carbon source gas are selected as values simultaneously satisfying an electric conductivity and an optical band gap of the p-type window layer 30a. If a boron impurity concentration is increased, an electric conductivity is increased but an optical band gap is reduced. In contrast, if a carbon concentration is increased, the electric conductivity is reduced but the optical band gap is increased. Accordingly, so as to achieve the electric conductivity and the optical band gap of the p-type window layer 30a, there is a demand for trade-off between the boron impurity concentration and the carbon concentration.

Finally, a deposition of the p-type window layer 30a is terminated by turning-off plasma (S27).

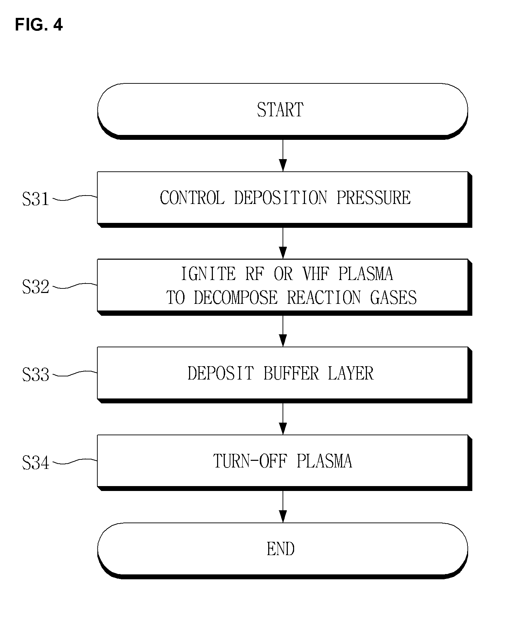

FIG. 4 is a flow chart illustrating a formation procedure of a buffer layer in the manufacturing method shown in FIG. 2.

Kinds of source gases used to form the hydrogen diluted p-type window layer 30a and the hydrogen-diluted buffer layer 30b can be the same. Further, set flow rates and deposition pressures of source gases for forming the p-type window layer 30a and the buffer layer 30b are different from each other. Accordingly, after deposition of the p-type window layer 30a is terminated, an angle valve of the reaction chamber connected to the pressure controller is completely opened, so that a mass flow controller controls a deposition flow amount of a buffer layer to be introduced.

As a set value of a pressure controller is changed to a deposition pressure of the buffer layer 30b by controlling the angle valve (S31). At this time, when exhaustion is performed according to a complete open of the angle valve, the mass flow controller is not closed completely. Accordingly, the time period when the pressure of the reaction chamber reaches the deposition pressure of the buffer layer 30b is reduced.

The deposition pressure of the buffer layer 30b may be in the range of 0.4 to 2 Torr so as to obtain thickness uniformity, high equality properties, and an appropriate deposition rate of the buffer layer 30b. If the deposition pressure of the buffer layer 30b is less than 0.4 Torr, the thickness uniformity and the deposition rate of the buffer layer 30b are deteriorated. If the deposition pressure of the buffer layer 30b is greater than 2 Torr, a powder occurs in a plasma reactor of PECVD system and the gas consumption is increased, which leads to an increase in running costs.

Meanwhile, a pressure in the reaction chamber reaches a deposition pressure of the buffer layer 30b, plasma is ignited in the reaction chamber to decompose the reaction gas (S32). Accordingly, the buffer layer 30b which is more highly diluted with hydrogen than the hydrogen dilution of the p-type window layer 30a is deposited on the p-type window layer 30a (S33).

The buffer layer 30b may have a thickness in the range of 3 nm to 8 nm. If the thickness of the buffer layer 30b is less than 3 nm, the recombination of photogenerated carriers at the interface between the p-type window layer 30a and the i-type absorber layer 40 cannot be sufficiently reduced. If the thickness of the buffer layer 30b is greater than 8 nm, optical absorption in the buffer layer 30b is increased to reduce a short-circuit current and to increase series resistance, which results in a reduction in a conversion efficiency.

Moreover, because the flow rates of source gases are maintained constant during the deposition of the buffer layer 30b, the buffer layer 30b has a constant optical band gap. Upon formation of the buffer layer 30b, a silane concentration being a reference factor of a hydrogen dilution ratio may be in the range of 0.5 to 5 %. If the silane concentration is less than 0.5 %, the p-type window layer is damaged due to reactive atomic hydrogen with a high energy. If the silane concentration is greater than 5 %, a deposition speed is high such that it is difficult to control the thickness. Further, a low hydrogen dilution reduces an electric conductivity such that a high electric field cannot be formed in the i-type absorber layer 40. Furthermore, a structural disorder of the buffer layer may be increased to increase a dangling bond density, such that the recombination of photogenerated electron-hole pairs in the interface between the p-type window layer 30a and the i-type absorber layer 40 cannot be sufficiently reduced.

Meanwhile, so as to minimize deterioration of a quantum efficiency in a short wavelength region by diffusing a boron from a p-type window layer 30a to i-type absorber layer 40, it is preferred that a boron impurity concentration of the buffer layer 30b has a minimum amount capable of maintaining high electric conductivity. Accordingly, upon formation of the buffer layer 30b, a flow rate ratio of the boron source gas (= the flow rate of boron source gas/the flow rate of SiH₄ gas) may be 100 to 2000 ppm.

Further, so as to prevent abrupt variation of an optical band gap and carbon composition between a hydrogen diluted p-type window layer 30a and an i-type absorber layer 40 with an intrinsic absorber, carbon concentration of the buffer layer 30b may range from 0.5 to 3 atomic %.

That is, if carbon concentration of the buffer layer 30b is less than 0.5 atomic %, an optical band gap difference between the p-type window layer 30a and the buffer layer 30b is increased, and a defect density at the interface between the p-type window layer 30a and the buffer layer 30b become higher, and thereby increasing the recombination rate. If the carbon concentration of the buffer layer 30b is greater than 3 atomic %, an electric conductivity of the buffer layer 30b is reduced. Accordingly, a high electric field cannot be formed in the i-type absorber layer 40, and matching balance of an optical band gap is broken, with the result that a function as the buffer layer is deteriorated.

If the buffer layer 30b with the thickness of 50 to 100 nm is deposited under the deposition condition of the buffer layer 30b, some crystalline silicon (c-Si) grains are embedded in a hydrogenated amorphous silicon-carbide (p-a-SiC:H) matrix. In addition, transverse-optic (TO) mode crystalline silicon peak appears in the vicinity of wavenumber of 520 nm in a Raman spectrum.

A deposition termination of the buffer layer 30b is achieved by turning-off plasma (S34). All the mass flow controllers of reaction gases are closed to prevent any gas from flowing into the reaction chamber and the angle valve connected to the mass flow controller is completely opened, such that material gases remaining in a reaction chamber are sufficiently evacuated to an exhaust line. Further, a deposition process of the i-type absorber layer 40 is followed.

Therefore, the recombination of the photogenerated electron-hole pairs is efficiently reduced at the interface between a p-type window layer 30a and an i-type absorber layer 40, and thereby improving conversion efficiency of a thin film silicon solar cell.

## Claims

1. A thin film silicon solar cell comprising:
a front transparent electrode (20) stacked on a transparent substrate (10);
a p-type window layer (30a) stacked on the front transparent electrode, and having a thickness in a range of 12 nm to 17 nm;
a buffer layer (30b) stacked on the p-type window layer, having a carbon concentration in a range of 0.5 to 3.0 atomic % and a thickness in a range of 3 to 8 nm;
an i-type absorber layer (40) stacked on the buffer layer;
an n-type layer (50) stacked on the i-type absorber layer; and
a metal rear electrode (70) stacked on the n-type layer.

2. The thin film silicon solar cell according to claim 1, wherein the buffer layer includes a hydrogenated amorphous silicon carbide.

3. The thin film silicon solar cell according to claim 1, wherein the p-type window layer has an electric conductivity of 1x10⁻⁶ S/cm.

4. The thin film silicon solar cell according to claim 1, wherein the p-type window layer includes a hydrogenated amorphous silicon carbide.

5. The thin film silicon solar cell according to claim 1, wherein the p-type window layer has a constant optical band gap.

6. A method for manufacturing a thin film silicon solar cell comprising:
stacking a front transparent electrode (20) on a transparent substrate (10);
stacking a p-type window layer (30a) on the front transparent electrode to have a silane concentration in a range of 5 to 10 % and a thickness in a range of 12 nm to 17 nm;
stacking a buffer layer (30b) stacked on the p-type window layer to have a silane concentration in a range of 0.5 to 5 % and a thickness in a range of 3 to 8 nm;
stacking an i-type absorber layer (40) on the buffer layer;
stacking an n-type layer (50) on the i-type absorber layer; and
stacking a metal rear electrode (70) on the n-type layer.

7. The method according to claim 6, wherein the buffer layer is formed by a flow rate ratio of an boron source gas ranging from 100 to 2000 ppm in the step of stacking the buffer layer.

8. The method according to claim 6, wherein the buffer layer has a carbon concentration in a range of 0.5 to 3.0 atomic %.

9. The method according to claim 6, wherein the p-type window layer and the buffer layer are formed by reaction gas comprising silane (SiH₄), hydrogen (H₂), boron source gas, and carbon source gas.

10. The method according to claim 6, wherein a temperature of the transparent substrate ranges from 100 to 200 □ during deposition of the p-type window layer.

11. The method according to claim 6, wherein a base pressure of a reaction chamber ranges from 10⁻⁷ to 10⁻⁵ Torr during deposition of the p-type window layer.

12. The method according to claim 6, wherein a deposition pressure of a reaction chamber ranges from 0.4 to 2 Torr during deposition of the p-type window layer.

13. The method according to claim 6, wherein the p-type window layer has an electric conductivity of 1x10⁻⁶ S/cm.
